**Europäisches Patentamt**

**European Patent Office**

**Office européen des brevets**

(19)

(11) Veröffentlichungsnummer: **0 241 088 B1**

# EUROPÄISCHE PATENTSCHRIFT

(12)

(45) Veröffentlichungstag der Patentschrift: **03.07.91**

(21) Anmeldenummer: **87200599.6**

(22) Anmeldetag: **01.04.87**

(51) Int. Cl.5: **B23K  1/08**, H05K 3/34,
B23K 3/06

(54) **Lötvorrichtung.**

(30) Priorität: **10.04.86 NL 8600905**

(43) Veröffentlichungstag der Anmeldung:
**14.10.87 Patentblatt  87/42**

(45) Bekanntmachung des Hinweises auf die
Patenterteilung:
**03.07.91 Patentblatt  91/27**

(84) Benannte Vertragsstaaten:
**CH DE FR GB IT LI NL**

(56) Entgegenhaltungen:
DE-U- 8 512 273
US-A- 3 000 342
US-A- 3 135 630
US-A- 3 923 002

PATENT ABSTRACTS OF JAPAN, Band 9, Nr.
311 (M-436)[2034], 7. Dezember 1985; & JP-
A-60 145 267 (FUJITSU K.K.) 31-07-1985

(73) Patentinhaber: **N.V. Philips' Gloeilampenfabrieken
Groenewoudseweg 1
NL-5621 BA Eindhoven(NL)**

(72) Erfinder: **Habraken, Johannes Cornelis
c/o INT. OCTROOIBUREAU B.V. Prof. Holstlaan 6
NL-5656 AA Eindhoven(NL)**

(74) Vertreter: **Melio, Jan Dirk et al
INTERNATIONAAL OCTROOIBUREAU B.V.
Prof. Holstlaan 6
NL-5656 AA Eindhoven(NL)**

## Beschreibung

Die Erfindung bezieht sich auf eine Lötvorrichtung für eine Karte mit gedruckter Verdrahtung und darauf festzulötenden Schaltungselementen, wobei die Lötvorrichtung mit einer Lötstation mit mindestens einer Düse und Mitteln zum Bilden mindestens einer Lötwelle und einer über der Lötstation entlangführenden Transportvorrichtung mit zwei parallelen Transportbahnen zum Unterstützen der zwei einander gegenüberliegenden Randstreifen der Karte versehen ist, wobei wenigstens bei der Lötstation ein die Karte unterstützendes ortsfestes Unterstützungselement vorgesehen ist.

Bei der Herstellung elektrischer Schaltungen werden elektrische Bauelemente auf einer Karte mit gedruckter Verdrahtung festgelötet, indem die Karte über ein sog. Lötbad geführt wird. Bei diesem Lötbad wird flüssiges Lötmaterial zu einer Welle gebildet, wobei die Wellenspitze die gedruckte Unterseite der Karte berührt. Auf diese Weise werden die vorher auf der Oberseite der Karte angeordneten Bauelemente mit der Verdrahtung verlötet. Das Lötbad kann hier mit einer oder zwei Wellen ausgebildet sein. Die Wellenspitze erstreckt sich quer zu der Transportrichtung und es ist bei derartigen Vorrichtungen notwendig, dass die Karte möglichst gerade bleibt, damit kein Lötmaterial auf die Oberseite der Karte gelangen kann. Zur Vermeidung des Durchhängens der Karte zwischen den Transportbahnen sind bereits mehrere Massnahmen getroffen worden.

So ist es allgemein bekannt, die Karte in einem Träger anzuordnen, der die Karte allseitig unterstützt. Dieses Verfahren ist nicht flexibel und aufwendig, weil die Karten in den Träger gesteckt und nach dem Löten wieder aus dem Träger entfernt werden müssen.

Ein Verfahren, bei dem keine Träger erforderlich sind ist aus IBM Technical Disclosure Bulletin Heft 25, Nr. 7B, Dezember 1982, Seite 3876/7 bekannt. Dabei werden der Vorder- und Hinterrand der Karte zwischen Verstärkungsprofilen festgeklemmt. Dieses Verfahren ist ebenfalls aufwendig, weil auch die Profile einzeln angebracht werden müssen. Eine andere Lösung, die einzelne Träger überflüssig macht, ist die, bei der wenigstens die Lötstation eine feste Führungsschiene zwischen den Transportbahnen aufweist, auf welche die Unterseite der Karte sich stützt. Da immer mehr Bauelemente an beiden Seiten der Karte, d.h. auch an der gedruckten Unterseite angebracht werden, die ebenfalls festgelötet werden müssen, ist eine derartige Führungsschiene nicht möglich, weil die Bauelemente, die vorher mit einem einfachen Heftmittel an der Karte befestigt sind, leicht abgestossen werden können (IBM) Technical Disclosure Bulletin, Heft 26, Nr. 5, Oktober 1983, Seite 2324).

Die Erfindung hat nun zur Aufgabe, die obengenannten Nachteile auszuschalten und schafft dazu eine Vorrichtung, die sich dadurch unterscheidet, dass das ortsfeste Unterstützungselement mindestens ein federnd nachgiebiges Stützglied aufweist das mit einem Träger verbunden ist.

Durch das federnd nachgiebige Stützglied wird die Karte vor Durchhängen geschützt. Dennoch können Bauelemente auf der Unterseite der Karte angeordnet werden, weil das Stützglied auf der Unterseite federnd nachgibt. Die Gefahr vor Abstossen wird damit vermieden.

Eine einfache Austauschbarkeit des federnd nachgiebigen Stützgliedes wird dadurch erhalten, dass es als ein mit einem Ende in einem Träger befestigter und sich von demselben erstreckender länglicher Körper ausgebildet ist. Weil das freie Ende des länglichen Körpers die Unterseite der Karte unterstützt, ist daher nicht nur die einfache Austauschbarkeit, sondern auch eine grosse Flexibilität gewährleistet.

Eine einwandfreie Führung ohne Gefahr vor Abstossen der Bauelemente ist dadurch gewährleistet, dass das freie Ende des länglichen Körpers gekrümmt ausgebildet wird.

In einer bevorzugten Ausführungsform der Lötvorrichtung nach der Erfindung sind mehrere längliche Körper zu einer oder mehreren Reihen quer zu der Transportrichtung gegliedert. Damit wird die Karte über die volle Breite zwischen den Transportbahnen unterstützt und jeder längliche Körper kann noch biegsamer ausgebildet werden, wodurch jede Gefahr vor Abstossen der Bauelemente ausgeschaltet ist.

Damit die richtige Höhe der Karte gegenüber der Wellenspitze beibehalten wird, empfiehlt es sich, die Reihen jeweils auf beiden Seiten der Düse anzuordnen.

Damit der längliche Körper die bei dem Lötbad auftretenden relativ hohen Temperaturen bestehen kann, wird es bevorzugt, jeden länglichen Körper aus einem Federstahldraht herzustellen.

Ein Ausführungsbeispiel der Erfindung ist in der Zeichnung dargestellt und wird im folgenden näher beschrieben. Es zeigen:

Fig. 1 eine schaubildliche Ansicht eines Teils einer Lötvorrichtung und zwar der Lötstation mit ortsfesten Stützgliedern nach der Erfindung,

Fig. 2 eine schaubildliche Draufsicht einer ggf. zu der Lötvorrichtung gehörende Transportvorrichtung mit einer darin aufgehängten Karte,

Fig. 3 einen Längsschnitt durch das Lötbad aus Fig. 1 mit zwei Lötwellen,

Fig. 4 eine schaubildliche Ansicht von unten einer in der Transportvorrichtung hängenden Karte, die durch die bevorzugte Ausführungsform der federnd nachgiebigen Stützglieder nach der Erfindung unterstützt werden.

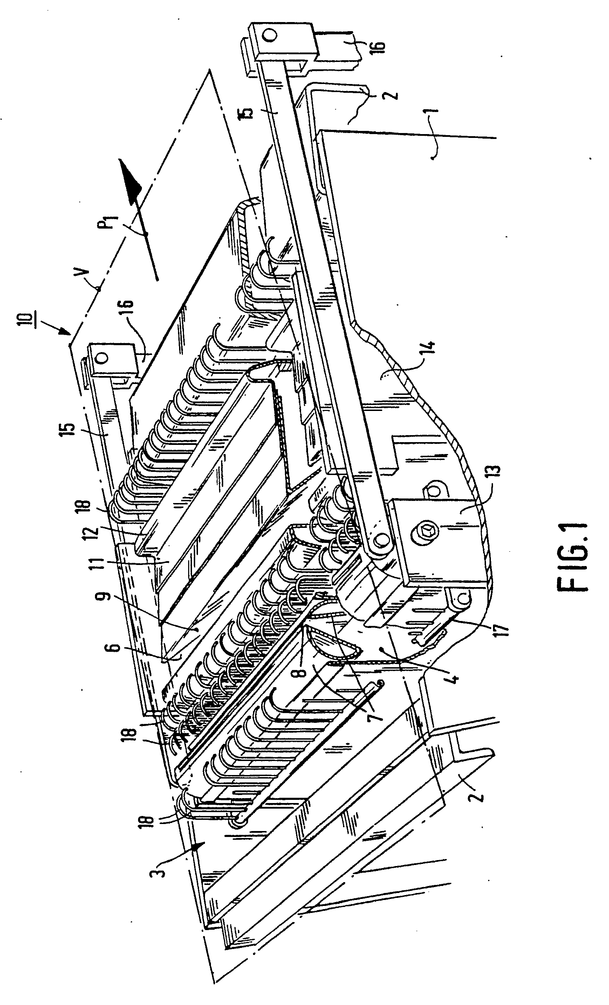

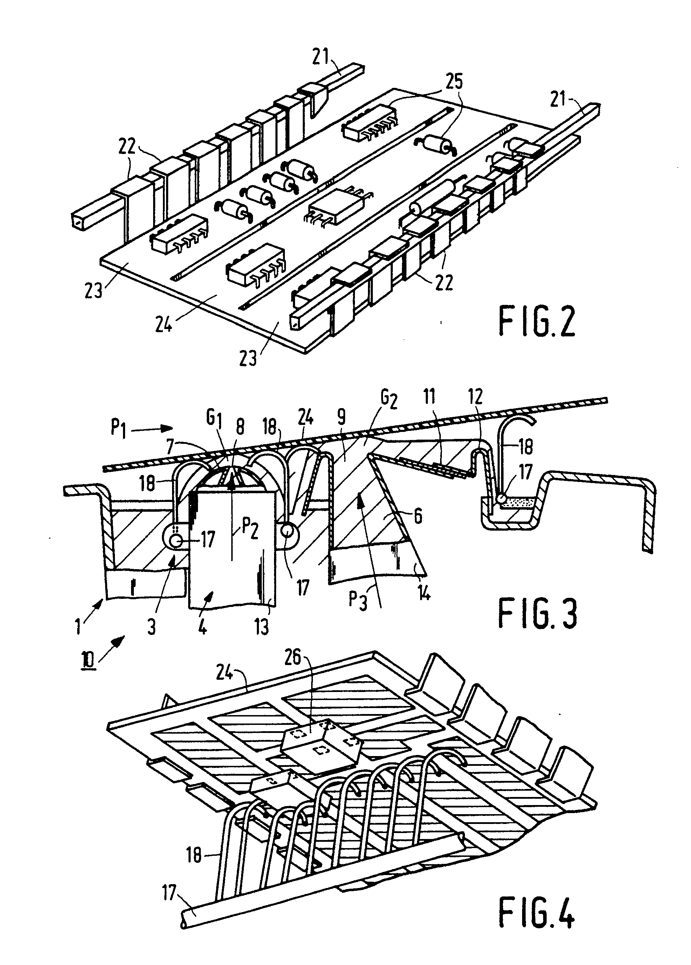

Die in den Fig. 1 und 3 dargestellte Lötstation 10 einer Lötvorrichtung dient nur als Beispiel und die Erfindung beschränkt sich nicht auf diese Ausführungsform.

Die Seitenplatten 1 des weiterhin nicht dargestellten Gestells sind durch Verstrebungselemente 2 derart miteinander verbunden, dass zwischen den Platten 1 ein wannenförmiger Raum 3 für eine Lötflüssigkeit vorgesehen werden kann. In diesem Raum 3 sind zwei vertikal angeordnete Schaften 4.6 vorgesehen, wobei die Schaft 4 auf der Oberseite durch eine Düse 7 abgeschlossen ist, die aus zwei schräg aufeinander zugehenden zylinderförmigen Segmenten besteht und zwar derart, dass auf der Oberseite ein Spalt 8 gebildet wird. Dieser Spalt 8 erstreckt sich zwischen den Seitenplatten 1 und zwar quer zu der untenstehend noch zu erläuternden Transportrichtung für die zu behandelnden Karten.

Die Schaft 6 weist ebenfalls auf der Oberseite einen Spalt 9 auf, der jedoch breiter ausgebildet ist als der Spalt 8 der Schaft 4. Auf der in Fig. 1 rechten Seite des Spaltes 9 ist eine Führungsplatte 11 mit einer stehenden Schwelle 12 vorgesehen.

Die Schaft 4 und die Schaft 6 sind durch Seitenplatten 13, 14 unterstützt, die gegenüber dem wannenförmigen Raum 3 auf an sich bekannte Weise in der Höhenrichtung einstellbar sind. Mit Hilfe von Schwenkarmen 15 und Hebeln 16 kann die Lage der Düse 7 eingestellt werden.

Nach der Erfindung ist die Lötvorrichtung mit federnd nachgiebigen Stützgliedern zum Unterstützen einer über der Lötstation 10 entlang zu führenden Karte versehen. Diese Stützglieder sind in diesem Fall als auf einem Träger 17 befestigte längliche Körper 18 ausgebildet, die sich von dem Träger 17 aufwärts erstrecken. Die länglichen Körper 18 sind auf beiden Seiten der Spalte 8 bzw. 9 zu Reihen gegliedert, so dass in der in Fig. 1 dargestellten Ausführungsform vier Reihen verwendet worden sind. Die länglichen Körper 18 sind an den von dem Träger 17 angewandten Enden je gekrümmt ausgebildet. Jeder Träger 17 ist an der Seitenplatte 13 bzw. 14 befestigt, so dass die Körper 18 zusammen mit den Trägern 17 und den Seitenplatten 13 und 14 in der Höhenrichtung einstellbar sind.

Wie obenstehend bereits erwähnt, bildet die in Fig. 1 dargestellte Lötstation 10 einen Teil einer Lötvorrichtung, die mit zwei parallelen Transportbahnen 21 nach Fig. 2 ausgebildet sein kann. Die Transportbahnen 21 sind als Transportketten ausgebildet und mit Aufhängeelementen 22 versehen, auf deren Unterseite die Seitenrandstreifen 23 einer zu behandelnden Karte 24 unterstützt werden. Die Karte 24 kann aus einer einzigen Karte oder aus zwei oder mehr Karten, in diesem Fall drei, aneinander befestigten, später einzeln zu verwendenden Kartenteilen bestehen.

Da die Karte 24 nur an den Seitenrandstreifen 23 unterstützt ist, dürfte es einleuchten, dass infolge der Wärme z.B. bei der Lötstation 10 nach Fig. 1, aber auch an anderweitig in der Vorrichtung, z.B. während des Vorwärmens, die Karte zwischen den Transportbahnen 21 zum Durchhängen neigt.

Die Transportbahnen 21 sollten etwas schräg aufwärts laufen und zwar derart, dass die Karte 24 in der Ebene V in Fig. 1 in der Richtung des Pfeiles P1 transportiert wird.

Die Wirkungsweise der obenstehend beschriebenen Vorrichtung wird anhand der Fig. 3 und 4 näher erläutert. Das Lötbad 3 ist mit Mitteln zum aufwärts Fördern von Lötflüssigkeit in den Schaften 4 und 6 entsprechend den Pfeilen P2, P3 versehen. Die Schaft 4 ist derart mit dem relativ engen Spalt 8 ausgebildet, dass die Lötflüssigkeit in einer Lötwelle G1 unter grossem Druck gegen die Unterseite einer Karte 24 gespritzt wird. Durch diese starke Lötwelle wird eine einwandfreie Benetzung der zu verlötenden Teile erhalten. Die Lötwelle G1 aus dem Spalt 8 wird auf beiden Seiten der zylinderförmigen Segmente 7 abgeführt, und zwar in den Raum 3 zurück. Die Lötflüssigkeit aus der Schaft 6 wird wegen des grösseren Spaltes 9 in einer relativ ruhige Welle G2 gleichmässig über den Rand des Spaltes 9 nach beiden Seiten abgeführt, wobei diese Welle zum Mitnehmen überflüssiger Lötflüssigkeit auf der Unterseite der Karte 24 dient, die infolge der starken ersten Welle G1 aus dem Spalt 8 zurückgeblieben ist. Die Wirkungsweise dieser Art von Lötbad ist an sich bekannt und wird weiterhin nicht näher erläutert. Es dürfte jedoch einleuchten, dass die Bemessung und die Einstellung der Schaften 4 und 6 sowie der Spalten 8 und 9 derart ist, dass bei genauer Einstellung gegenüber den Transportbahnen 21, die Spitzen der Wellen G1 und G2 bei dem Spalt 8 bzw. 9 die Unterseite der Karte 24 genau berühren.

Die obenstehend erwähnte Gefahr vor Durchhängen der Karte 24 zwischen den Transportbahnen 21 und vor Überspülen der Karte 24 mit Lötflüssigkeit wird durch die federnd nachgiebigen Elemente in Form der Reihen länglicher Körper 18 quer zu der Transportrichtung P1, welche die Karte 24 auf der Unterseite über die volle Breite unterstützen, vermieden.

Auf der Oberseite ist die Karte 24 mit herkömmlichen Bauelementen 25 versehen. Wenn die Karte 24 auf der Unterseite mit Bauelementen 26 versehen ist, die mittels eines Klebers daran befestigt sind, werden diese Bauelemente 26 nicht von den länglichen Körpern 18 abgestossen werden, da diese so biegsam sind, dass sie beiseite oder nach unten biegen. Die übrigen länglichen Körper 18 unterstützen die Karte nach wie vor in der richtigen Höhe.

Durch die gekrümmten Enden der länglichen Körper wird es keine Probleme geben, wenn diese Körper gegen die Bauelemente 26 stossen bzw. sie wieder verlassen.

Die länglichen Körper 18 sind leicht austauschbar und zwar wegen der Tatsache, dass sie entfernbar in weiterhin nicht dargestellten Ausnehmungen des Trägers 17 angeordnet sind.

Die drahtförmige Ausbildung des länglichen Körpers 18 lässt sich auch durch eine mehr streifenförmige Gestalt, z.B. ein Federblatt, ersetzen. Die Träger 17 können auch höher angeordnet sein und die länglichen Körper 18 können sich mehr horizontal erstrecken.

Es ist auch möglich, dass die federnd nachgiebigen Streifen bzw. Drähte sich über die volle Länge des Lötbades zwischen zwei auf beiden Seiten desselben angeordneten Trägern erstrecken.

Die federnd nachgiebigen Unterstützungselemente nach der Erfindung brauchen auch nicht nur bei einer einzigen Lötstation angeordnet zu sein, sondern können auch bei anderen Stationen in der Lötvorrichtung, vorgesehen sein.

## Ansprüche

1. Lötvorrichtung für eine Karte (24) mit gedruckter Verdrahtung und darauf festzulötenden Schaltungselementen (25, 26), wobei die Lötvorrichtung mit einer Lötstation (10) mit mindestens einer Düse (7) und Mitteln zum Bilden mindestens einer Lötwelle (G1, G2) und einer über der Lötstation (10) entlangführenden Transportvorrichtung mit zwei parallelen Transportbahnen (21) zum Unterstützen der zwei einander gegenüberliegenden Randstreifen (23) der Karte (24) versehen ist, wobei wenigstens bei der Lötstation (10) ein die Karte (24) unterstützendes ortsfestes Unterstützungselement vorgesehen ist, dadurch gekennzeichnet, dass das ortsfeste Unterstützungselement mindestens ein federnd nachgiebiges Stützglied aufweist das mit einem Träger (17) verbunden ist.

2. Vorrichtung nach Anspruch 1, dadurch gekennzeichnet, dass das federnd nachgiebige Stützglied als ein mit einem Ende in dem Träger (17) befestigter und sich von demselben erstreckender länglicher Körper (18) ausgebildet ist.

3. Vorrichtung nach Anspruch 2, dadurch gekennzeichnet, dass ein freies Ende des länglichen Körpers (18) gekrümmt ist wobei das freie Ende von der Karte abgewendet ist.

4. Vorrichtung nach Anspruch 2 oder 3, dadurch gekennzeichnet, dass mehrere längliche Körper (18) zu einer oder mehreren Reihe quer zu der Transportrichtung (P1) gegliedert sind.

5. Vorrichtung nach Anspruch 4, dadurch gekennzeichnet, dass die Reihen jeweils auf beiden Seiten der Düse (7) angeordnet sind.

6. Vorrichtung nach einem der vorstehenden Ansprüche, dadurch gekennzeichnet, dass jeder längliche Körper (18) aus einem Federstahldraht hergestellt ist.

## Claims

1. A soldering device for a printed circuit board (24) and circuit elements (25,26) to be soldered on said board, this soldering device being provided with a soldering station (10) with at least one nozzle (7), means for forming at least one soldering wave (G1, G2), and a transport device extending longitudinally over the soldering station (19), and comprising two parallel transport tracks (21) for supporting the two opposing edge strips (23) of the said board (24), while a stationary supporting member supporting the board (24) is arranged at least near the soldering station (10), characterized in that the stationary supporting member comprises at least one resiliently yielding supporting element which is connected to a carrier (17).

2. A device as claimed in Claim 1, characterized in that the resiliently yielding supporting member is in the form of an elongate body (18) secured with one end in a carrier (17) and extending thereform.

3. A device as claimed in Claim 2, characterized in that a free end of the elongate body (18) is curved, which free end is remote from the carrier.

4. A device as claimed in Claim 2 or 3, characterized in that several elongate bodies (18) are arranged in one or more rows at right angles to the direction of transport (P1).

5. A device as claimed in Claim 4, characterized in that the rows are arranged each time on either side of the nozzle (17).

6. A device as claimed in any one of the preceding Claims, characterized in that each elongate body (18) is manufactured from a wire of spring steel.

**Revendications**

1.  Dispositif de soudage pour une carte (24) munie d'un circuit imprimé et de composants (25, 26) devant être fixés sur celle-ci par soudage, le dispositif de soudage comportant un poste de soudage (10) muni d'au moins une buse (7) et de moyens pour former au moins une vague de soudage (G1, G2) et un dispositif transporteur servant au transport sur le poste de soudage (10) et qui est muni de deux voies de transport parallèles (21) destinées à soutenir les deux bandes marginales opposées (23) de la carte (24), un élément de support stationnaire soutenant la carte (24) étant prévu au moins dans le poste de soudage, caractérisé en ce que l'élément de support stationnaire présente au moins un élément d'appui élastiquement déformable relié à un support (17).

2.  Dispositif selon la revendication 1, caractérisé en ce que l'élément d'appui élastiquement déformable est réalisé sous la forme d'un corps oblong (18) fixé par une extrémité dans le support (17) et s'étendant à partir de celui-ci.

3.  Dispositif selon la revendication 2, caractérisé en ce qu'une extrémité libre du corps oblong (18) est courbée, l'extrémité libre étant située à l'opposé de la carte.

4.  Dispositif selon la revendication 2 ou 3, caractérisé en ce que plusieurs corps oblongs (18) sont réunis en une ou plusieurs rangées transversales à la direction de transport (P1).

5.  Dispositif selon la revendication 4, caractérisé en ce que les rangées sont disposées chacune des deux côtés de la buse (7).

6.  Dispositif selon l'une quelconque des revendications précédentes, caractérisé en ce que chaque corps oblong (18) est formé d'un fil d'acier à ressort.

FIG.1

FIG.2

FIG.3

FIG.4